Europäisches Patentamt

(19) European Patent Office

Office européen des brevets

(11) Veröffentlichungsnummer: **0 000 863**
**B1**

(12) **EUROPÄISCHE PATENTSCHRIFT**

(45) Veröffentlichungstag der Patentschrift: 15.07.81

(51) Int. Cl.³: **H 01 L 23/56, H 01 L 27/08**

(21) Anmeldenummer: **78100173.0**

(22) Anmeldetag: **15.06.78**

(54) Temperaturkompensierter integrierter Halbleiterwiderstand.

(30) Priorität: **18.08.77 US 825759**

(43) Veröffentlichungstag der Anmeldung:
**07.03.79 Patentblatt 79/5**

(45) Bekanntmachung des Hinweises auf die Patenterteilung:
**15.07.81 Patentblatt 81/28**

(84) Benannte Vertragsstaaten:
**DE FR GB**

(56) Entgegenhaltungen:
**FR - A - 2 351 505**
**US - A - 3 484 658**
**US - A - 3 700 977**

ELECTRONICS, vol. 48, 23—1—1975,
New York
W. E. OTT: "Monolithic converter augments acmeasurement capabilities" pages 79—83.

(73) Patentinhaber: **International Business Machines Corporation**
**Armonk, N.Y. 10504 (US)**

(72) Erfinder: **Bergeron, David Leo**
**7606 Wedgewood Drive**
**Manassas, Virginia 22110 (US)**
Erfinder: **Stephens, Geoffrey Brownell**
**10 Mercer Court**
**Catlett, Virginia 22019 (US)**

(74) Vertreter: **Jost, Ottokarl, Dipl.-Ing.**
**Schönaicher Strasse 220**
**D-7030 Böblingen (DE)**

Temperaturkompensierter integrierter Halbleiterwiderstand

Die Erfindung bezieht sich auf einen temperaturkompensierten integrierten Halbleiterwiderstand nach dem Oberbegriff des Anspruchs 1.

Bekannte integrierte Halbleiterwiderstände weisen ein Widerstands-/Temperaturverhalten auf, das durch ihren Widerstandstemperaturkoeffizienten (TCR) bestimmt ist. Es wurden bisher zahlreiche Versuche unternommen, den Widerstandstemperaturkoeffizienten zu verringern.

Es wurden auch schon Schaltungsvorschläge gemacht und verwendet, um die Widerstandsänderungen hinsichtlich der Temperatur dadurch zu kompensieren, daß eine PN-Sperrschicht mit einem entgegengesetzten Widerstandstemperaturkoeffizienten in Reihe mit dem Widerstand geschaltet wurde.

Diese bekannten Maßnahmen zur Lösung des Problems des Temperaturgangs von integrierten Halbleiterwiderständen waren begrenzt hinsichtlich des zu kompensierenden Widerstandsbereichs, des linearen Verlaufs des Serienwiderstands, des Temperaturbereichs, über den der Widerstandstemperaturkoeffizient kompensiert werden konnte und in den Anforderungen, die sich aus den Kompensationsschaltungen selbst ergaben.

In der US—PS 3 683 306 ist beispielsweise ein Verfahren beschrieben, mit dem der Widerstandstemperaturkoeffizient auf Null gebracht werden soll, indem das Mittel der Ionenimplantation eingesetzt wird, um Gefügeschäden in dem Gebiet zu verursachen, in das der integrierte Halbleiterwiderstand eingebracht werden soll.

Aus der US—PS 3 700 977 ist ein integrierter Halbleiterwiderstand mit eines Widerstandsgebiet des einem Leitfähigkeitstyps in einer Epitaxieschicht des entgegengesetzten Leitfähigkeitstyps, das im Abstand voneinander aufweisende elektrische Kontakte besitzt, bekannt, bei dem einer der elektrischen Kontakte auf einem Referenzpotential liegt und bei dem die Ausgangsspannung eines Impedanzwandlers der Epitaxialschicht in der Weise zugeführt wird, daß längs des Widerstandsgebietes und des angrenzenden Epitaxialgebietes die gleiche Spannung abfällt. Dadurch läßt sich zwar der Einfluß von Störkapazitäten ausschalten, nicht aber eine Temperaturkompensation des eigentlichen Widerstands erreichen.

Temperaturfühler, die eine an ihnen anliegende Temperatur in eine andere physikalische Größe, beispielsweise eine Spannung konvertieren, sind ebenfalls an sich bekannt. Aus der Zeitschrift "Electronics", Vol. 48, vom 23. Januar 1975., Seiten 79 bis 83 ist ein Temperaturfühler bekannt, der einen NPN Transistor sowie einen eindiffundierten Widerstand aufweist. Bei dieser Transistor-Widerstandsanordnung werden Temperaturänderungen in Basis-Emitterspannungsänderungen konvertiert. Da es sich um ein Thermoelement für die Messung von Effektivwerten von Spannungen über einem breiten Frequenzbereich sowie von Leistung und Gewinn von Verstärkern handelt, ist dieses Element als Temparaturfühler zur Kompensation des Temperaturganges von integrierten Widerständen nicht optimiert und somit nicht direkt verwendbar.

Dann ist in der US—PS 3 947 866 ein integrierter Halbleiterwiderstand beschrieben, der in seinem mittleren Teil dicker ist, als an seinen äußeren Enden, so daß der dickere Mittelteil einen negativen Widerstandstermperaturkoeffizienten und die äußeren Teile einen positiven Widerstandstemperaturkoeffizienten haben. Es wird in der Beschreibung dieser US—PS angegeben, daß der Widerstand insgesamt einen Widerstandstemperaturkoeffizienten Null erreicht.

Alle diese bekannten Lösungen des Problems, die Widerstandsänderung eines Widerstandes in Abhängigkeit von seiner Betriebstemperatur zu kompensieren, haben zwar dieses Ziel erreicht, aber andere Probleme geschaffen, die insgesamt nachteilig sind. So ist beispielsweise eine Zunahme der Komplexität der Herstellungsprozesse ebenso von Nachteil, wie die Tatsache, daß der Bereich der Widerstandswerte, die erzielbar sind, begrenzt ist, sowie daß auch der Temperaturbereich begrenzt ist, über den eine gewünschte Widerstands-/Temperaturkompensation möglich ist.

Hier will die Erfindung Abhilfe schaffen, indem sie eine verbesserte Widerstands-/Temperaturkompensation angibt, die die genannten Nachteile, d.h. Komplexität des Herstellungsprozesses, Begrenzung des Widerstandsbereichs, sowie Begrenzung des Widerstands/Temperaturkompensationsbereichs, vermeidet.

Gelöst wird diese Aufgabe der Erfindung durch die im Hauptanspruch angegebenen Merkmale.

Vorteilhafte Ausgestaltungen und Weiterbildungen des Gegenstandes der Erfindung sind den Unteransprüchen zu entnehmen.

Durch die Erfindung wird also der Vorteil erzielt, daß zur Herstellung eines integrierten, temperaturkompensierten Halbleiterwiderstandes normale, unkomplizierte Prozesse verwendet werden können. Außerdem können Widerstandswerte über einen großen Bereich erzeugt werden, die zudem noch in weiten Temperaturbereichen kompensierbar sind.

Im folgenden wird ein Ausführungsbeispiel der Erfindung anhand der Fign. erläutert.

Es zeigen:

Fig. 1 eine schematische Querschnittsdarstellung eines durch Ionenimplantation in eine Epitaxieschicht eingebauten Widerstands und das Blockschaltbild einer Temperaturkom-

pensations-schaltung,

Fig. 2 eine graphische Darstellung des Verlaufs des Widerstandstemperaturkoeffizienten (TCR) eines durch Ionenimplantation hergestellten Widerstandes als Funktion des Schichtwiderstandes und

Fig. 3 eine graphische Darstellung des Verlaufs des Widerstandsspannugskoeffizienten (VCR) als Funktion des nominellen Schichtwiderstands für einen Widerstand, der aus den gleichen Prozeßbedingungen und der gleichen Implantations-dosis entstanden ist, wie der in Fig. 2 zugrundegelegte.

Der Widerstand eines durch Ionenimplantation oder Diffusion hergestellten Widerstands, ist eine Funktion der Temperatur, bei der er betrieben wird. Die hier dargestellte Temperaturkompensationsschaltung basiert auf der Erkenntnis, daß der Widerstand eines solchen Widerstandes auch eine Funktion der Potentialdifferenze zwischen dem Anschluß des Widerstands, der des höchste positive Potential führt und der Epitaxieschicht selbst ist. Eine Temperaturkompensation wird dadurch bewirkt, daß ein Temperaturfühler mit der Epitaxieschicht verbunden ist, der eine Ausgangsspannung führt, die sich gegenläufig zum Widerstandstemperaturkoeffizienten des Widerstandes verändert. Daher nähert sich die Gesamtwiderstands-änderung des betrachteten durch Ionenimplantation oder Diffusion hergestellten Widerstandes über einen weiten Bereich von Temperaturschwankungen dem Wert Null.

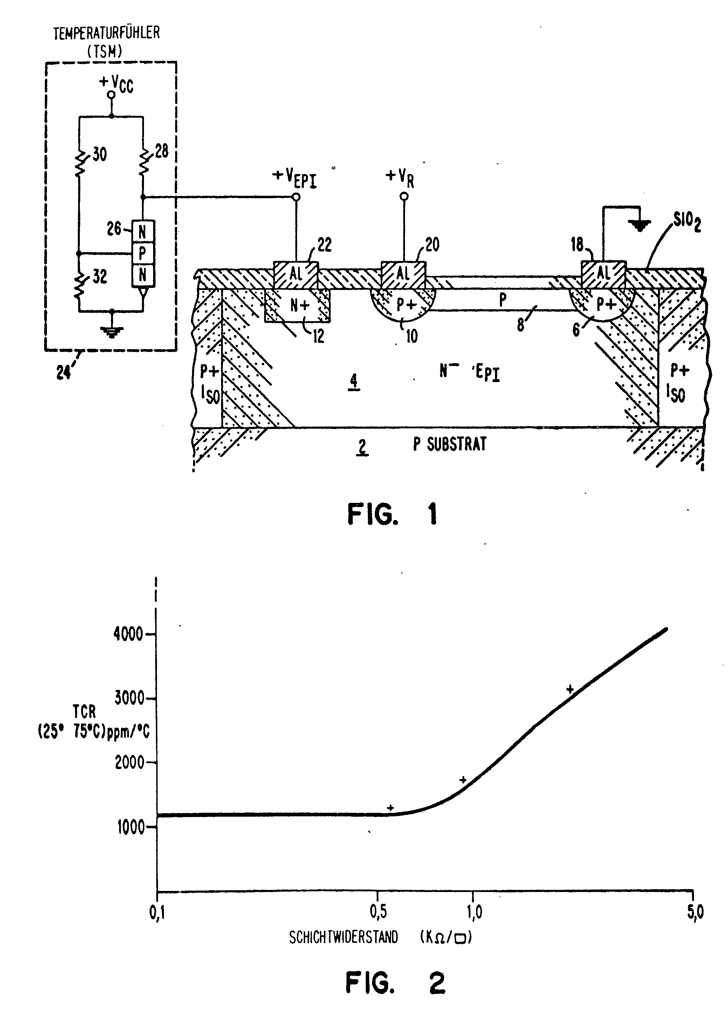

In Fig. 1 ist eine N-leitende epitaktische Halbleiterschicht 4 dargestellt, die auf einem P-leitenden Substrat 2 aufgebracht ist. Die P-dotierten Kontaktbereiche sind bei 6 und 10 dargestellt, wobei sich zwischen ihnen in der Epitaxieschicht der Widerstand 8 aus P-dotiertem Material befindet. Der Widerstand 8 ist als ein durch Ionenimplantation hergestellter Widerstand dargestellt, obwohl das Prinzip der Erfindung auch auf nach anderen Prinzipien hergestellte Widerstände anwendbar ist, für die eine Widerstandstemperaturkompensation gewünscht wird; d.h. es kann auch ein in die Epitaxieschicht $E_{PI}$ hineindiffundierter Widerstand anstelle des durch Ionenimplantation hergestellten Widerstandes verwendet werden.

Der Widerstand des mittels Ionenimplantation hergestellten Widerstands 8 nimmt mit steigender Temperatur zu. Um diesen Widerstandszuwachs zu kompensieren, muß dafür gesorgt werden, daß der Widerstandsspannungskoeffizient der Potentialdifferenz zwischen der Epitaxieschicht 4 und dem Widerstand 8 eine gleiche und entgegengerichtete Widerstandsänderung des Widerstandes 8 bewirkt. Die PN-Sperrschicht, die den Widerstand 8 in der Epitaxieschicht 4 umgibt, hat eine Verarmungszone, deren Dicke mit abnehmender Potentialdifferenz zwischen dem Widerstand 8 und der Epitaxieschicht 4 abnimmt. Wenn die Temperatur der Anordnung ansteigt, wodurch auch der Wert des Widerstandes 8 zunimmt, wird zur Kompensation dieses Temperaturganges die Potentialdifferenz zwischen der Epitaxieschicht 4 und dem Widerstand 8 abgesenkt, was zur Folge hat, daß die den Widerstand 8 umgebende Verarmungszone den Querschnitt des Widerstandes 8 weniger einschnürt, wodurch wiederum durch den so vergrößerten Querschnitt der Wert des Widerstandes 8 kleiner wird. Um dieses durchzuführen, ist ein Temperaturfühler 24 über einen Kontakt 12 und einen Aluminiumkontakt 22 an die Epitaxieschicht 4 angeschlossen, wobei die genannte Schaltung ihre Ausgangsspannung $V_{EPI}$ in dem Maße absenkt, wie die Temperatur ihrer Umgebung ansteigt. Wie an sich bakannt ist, sind auch an den Positionen 18 und 20 Kontakte angebracht. Durch ein Absenken des Potentials $V_{EPI}$ mit zunehmender Temperatur, wird daher die gewünschte Widerstanskompensation für den Widerstand 8 bewirkt.

Der Temperaturfühler 24 besteht aus zwei parallel geschalteten Spannungsteilern, die zwischen einer Spannung $+V_{CC}$ und Erde angeschlossen sind. In dem ersten Spannungsteiler bilden die Teilwiderstände 30 und 32 einen Spannungsteiler mit einem Abgriff, der an die Basis eines NPN-Transistors 26 angeschlossen ist. Der zweite Spannungsteiler besteht aus einem Teilwiderstand 28 und dem NPN-Transistor 26, deren gemeinsamer Verbindungspunkt auch der Ausgangsknoten der Schaltung für die Erzeugug der Spannung $V_{epi}$ ist. Der Spannungsabfall zwischen $V_{CR}$ und der Basis des NPN-Transistors 26, wird mit Hilfe der konstanten Größe von $V_{CC}$ und dem konstanten Verhältnis der Teilwiderstände 30 und 32 konstant gehalten. Auf diese Weise wird auch die Basis- Emitterspannung des NPN-Transistors 26 konstant gehalten. Die PN-Sperrschicht am Emitter-Basis-Übergang des NPN-Transistors 26 verändert jedoch ihre Stromflußcharakteristik mit der Änderung der Umgebungstemperatur.

Wie oben bereits erwähnt wurde, wird die Potentialdifferenz zwischen dem Widerstand 8 und der Epitaxieschicht 4 gesenkt, um eine Widerstandsverringerung entsprechend des Widerstandsspannungskoeffizienten des Transistors zu erreichen. Da sowohl der Widerstand, als auch die Epitaxieschicht bezüglich des Widerstandes positiv vorgespannt sind, muß der Epitaxieschicht 4 eine ins Negative driftende Spannungsänderung aufgezwungen werden, um den Widerstandswert des Widerstandes 8 zu verringern ($V_{EPI} > V_R$ in Fig. 1). Um eine ins Negative driftende Spannung zu erzeugen, muß or Temperaturfühler 24 mit steigender Temperatur eine ins Negative gehende Änderung der Spannung $V_{EPI}$ generieren. Dieses wird durch den NPN-Transistor 26 erreicht, der mit steigender Temperatur einen größer werdenden Stromfluß zur Folge hat, wodurch auch ein größerer Strom durch den mit ihm in Serie geschalteten Teilwiderstand 28 fließt und somit dessen Spannungsabfall größer und das Potential an seinem Ausgangsknoten kleiner wird, so daß auch die Spannung $V_{EPI}$ mit steigender Temperatur abnimmt. Durch geeignete Auswahl der Größen der Teilwiderstände 28, 30 und 32, kann die Größe der Veränderung von $V_{EPI}$ erreicht werden, die eine Verringerung des Widerstands 8 gemäß seinem Widerstandsspannungskoeffizienten bewirkt, die exakt dem Ansteigen des Widerstandswertes des Widerstands 8 entsprechend seines Temperaturzuwachses entgegenwirkt.

Durch Einhaltung eines konstanten Basis-Emitterpotentails längs des Teilwiderstandes 32 und durch das Anheben der Leitfähigkeit des NPN-Transistors 26 mit der Temperatur, kann ein größerer Strom durch den Teilwiderstand 28 getrieben werden, der die Größe der Spannung $V_{EPI}$ an seinem Ausgansknoten in der gewünschten Wiese verringert.

Fig. 2 zeigt eine graphische Darstellung des Widerstandstemperaturkoeffizienten über dem Widerstand der Schicht für durch Ionenimplantation hergestellte Widerstände, bei einer bestimmten Gruppe von Prozeßbedingungen über einem weiten Bereich der Ionenimplantationsdosis, die Schichtwiderstände von 100 Ohm je Flächenelement bis 5000 Ohm je Flächenelement ergeben. Der Widerstandstemperaturkoeffizient erstreckt sich dabei über einen Bereich von etwa 1100 Teile je Million und je Grad Celsius (ppm/°C) bis über 4000 ppm/°C für diesen Bereich des Schichtwiderstands. Andere Kurven mit höherem oder niedrigerem Widerstandstemperaturkoeffizienten können dadurch erreicht werden, daß der Satz von Prozeßbedingungen verändert wird, insbesondere die Implantationsenergie, die Oxyddicke, die Hintergrundkonzentration (Epitaxie) und Erhitzungsdauer und -temperatur des der Implantation nachgeschalteten Wärmeschrittes.

Aus Fig. 2 ist beispielsweise zu sehen, daß ein Widerstand bei einem Schichtwiderstand von 5000 Ohm je Flächenelement einen Widerstandstemperaturkoeffizienten von etwa 4000 ppm/°C hat. Daher wird ein Widerstand, dessen Widerstandswert 10 000 Ohm bei 25°C ist, einen Widerstand von 10 000 + 10 000 × 4 000 × $10^{-6}$ × (75—25) oder 12 000 Ohm bei 75°C haben.

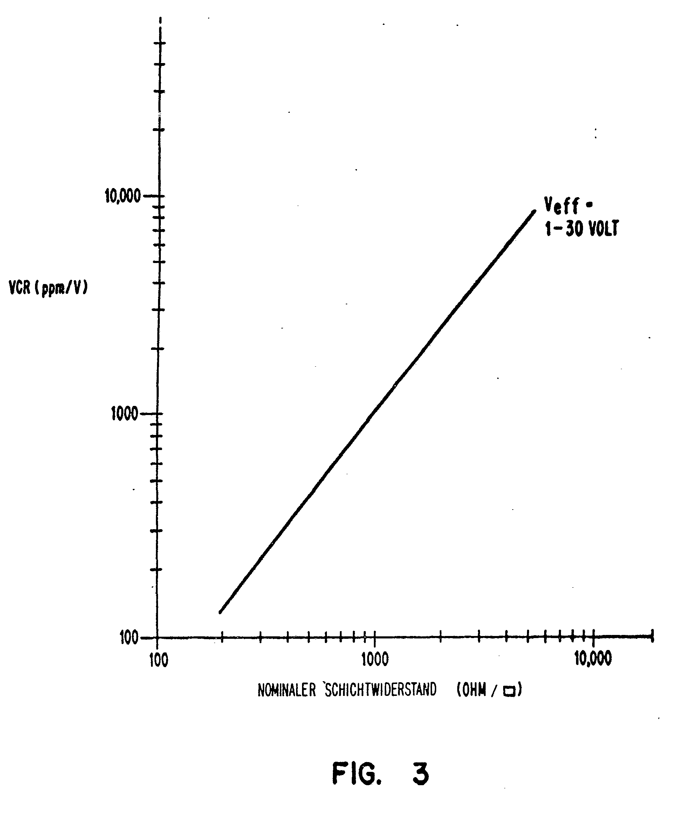

Fig. 3 zeigt eine graphische Darstellung des Widerstandsspannungskoeffizienten (VCR) über dem nominellen Schichtwiderstand, für einen nach den gleichen Prozeßbedingungen hergestellten Widerstand, wie der im Zusammanhang mit Fig. 2 erläuterte. Die Widerstandsänderung mit der Spannung ist von der Ladungsträgerverarmung längs der PN—Sperrschicht abhängig, die zwischen dem Widerstandsbereich und der entgegengesetzt dotierten Epitaxieschicht gebildet ist. Die Dicke des an Ladungsträgern verarmten Bereichs ist eine Funktion der Dotierungskonzentration auf beiden Seiten der Sperrschicht, sowie der Potentialdifferenz (elektrisches Feld) zwischen beiden Seiten der Sperrschicht.

Das Potential (Vorspannung) über der Sperrschicht, ist sowohl eine Funktion des an die Epitaxieschicht angelegten Potential relativ zu dem positiven Ende des Widerstandes und dem Potential, das an beide Enden des Widerstandes angelegt wird. Die Gesamtwirkung dieser beiden Potentiale kann ausgedrückt werden als eine kombinierte effektive Spannung ($V_{eff}$), die in folgendem algebraischen Ausdruck erfaßbar ist:

$$V_{eff} = V_{EPI} - (+V_R) + \frac{V_R}{2}$$

Diese Spannung kann als mittlere Potentialdifferenz über der Widerstands-Epitaxiesperrschicht angesehen werden.

Aus den in den Fign. 2 und 3 dargestellten Beziehungen ist zu sehen, daß ein Anwachsen des Widerstandes infolge steigender Temperatur durch ein Absenken der effektiven Spannung über der PN-Sperrschicht ausgeglichen werden kann.

Wenn beispielsweise ein Widerstand von 5000 Ohm je Flächenelement bei 25°C ein TCR von 4000 ppm/°C und ein VCR von 10 000 ppm/V hat, dann hat er annähernd einen konstanten Wert von 25°C bis 75°C, wenn die Vorspannung der Epitaxieschicht gegenüber dem positiven Ende des Widerstandes von 30 Volt bei 25°C bis 10 Volt bei 75°C eingestellt wird. Die Einstellung der Vorspannung an der Epitaxieschicht wird von dem in Fig. 1 dargestellten Temperaturfühler 24 vorgenommen, der in unmittelbarer Nähe des Widerstandes, dessen Temperatur dann zu kompensieren ist, angebracht ist, so daß die Temperatur des Widerstands die gleiche oder fast die gleiche ist, wie die Temperatur des Temperatur 24.

Beispiele anderer möglicher Realisierungen der Kompensation des Temperaturganges können darin gesehen werden, daß eine P-Zone innerhalb einer N-Epitaxieschicht und die Epitaxieschicht verwendet wird, um einen Widerstand zu bilden, dessen Temperaturänderung durch Änderungen der Verarmungszone kompensiert wird, die durch die umgekehrt vorgespannte P-Zone gebildet wird.

Gemäß einem anderen Ausführungsbeispiel wird ein Widerstand dadurch gebildet, daß eine P-Zone in einer N-Epitaxieschicht, beispielsweise einer solchen, die zur Herstellung einer Transistorbasis-Zone verwendet wird, die von einer schmaleren N+—Zone überlappt wird, wie es bei einer solchen der Fall ist, die dazu verwendet wird, um eine Transistoremitterzone zu bilden. Es handelt sich hierbei also um einen sogenannten Pinch-Widerstand. Die Kompensation des Temperaturganges des P-Widerstands wird dadurch erreicht, daß die entgegengesetzte Vorspannung an der N+—Zone und der Epitaxieschicht bezüglich der P-Widerstandszone variiert wird. Das ausführlich erläuterte Ausführungsbeispiel kann erweitert
werden, indem mehrere Widerstände in einer
gemeinsamen Epitaxieschicht kompensiert werden, wobei nur dieser eine Temperaturfühler
mit der Kompensationsschaltung nach Fig. 1
verwendet wird.

## Patentansprüche

1. Temperaturkompensierter integrierter Halbleiterwiderstand mit einem Widerstandsgebiet des einen Leitfähigkeitstyps in einer Epitaxieschicht des entgegengesetzten Leitfähigkeitstyps, das einen Abstand von einander aufweisende elektrische Kontakte besitzt, dadurch
gekennzeichnet, daß einer der elektrischen Kontakte (18; Fig. 1) auf einem Referenzpotential
liegt, der Widerstand (8) einen positiven Widerstandsspannaungskoeffizienten (VCR) und einen
vorgegebenen Widerstandstemperaturkoeffizienten (TCR) hat, ein Temperaturfühler (24)
vorgesehen ist, der auf der integrierten Schaltung dicht am Widerstand liegt und dessen Ausgangsspannungsanschluß an die Epitaxieschicht (4) angeschlossen ist und dessen Spannungsbezugsanschluß auf Referenzpotential
liegt, und daß die Ausgangsspannungscharakteristik des Temperaturfühlers bezüglich der
Temperatur an seinem Ausgangsanschluß einen
zum Widerstandsspannungskoeffizienten des
Widerstandes derart entgegengesetzten Verlauf hat, daß die Widerstandsänderungen des
Widerstandes bezüglich der Temperatur durch
diese Spannungsänderungen des Temperaturfühlers an der Epitaxieschicht kompensierbar
sind.

2. Temperaturkompensierter integrierter Halbleiterwiderstand nach Anspruch 1, dadurch
gekennzeichnet, daß der mit seinem Ausgansanschluß über einen ersten Kontakt (22,
12) an die Epitaxieschicht (4) angeschlossene
Temperaturfühler (24) aus zwei parallel geschalteten Spannungsteilern (26, 28, 30, 32)
besteht, von denen der erste Spannungsteiler
aus einem Teilwiderstand (28) und aus einem
negativen Temperaturgang aufweisenden
steuerbaren Widerstand (26) besteht, dessen
Steuerelektrode mit dem Abgriff des zweiten
Spannungsteilers zwischen seinen Teilwiderständen (30, 32) verbunden ist und daß der
Ausgangsspannungsanschluß mit dem Abgriff
des ersten Spannungsteilers zwischen dem
steuerbaren Widerstand (26) und dem Teilwiderstand (28) identisch ist und die Versorgungsspannung ($V_{cc}$) zwischen der Verbindung zwischen den beiden Teilwiderständen
(28, 30) der zwei Spannungsteiler angeschlossen ist.

3. Temperaturkompensierter integrierter
Halbleiterwiderstand nach Anspruch 2, dadurch
gekennzeichnet, daß der steuerbare Widerstand (26) aus einem NPN-Transistor gebildet
ist, dessen Emitter-Basisspannung durch einen
konstanten Spannungsabfall zwischen der Versorgungsspannung ($V_{cc}$) und der Basis des
Transistors, bewirkt durch eine konstante Versorgungsspannung und eine festes Verhältnis
der Teilwiderstände (30, 32) des zweiten Spannungsteilers, konstant gehalten wird, so daß
sich der Stromfluß durch die PN-Sperrschicht
zwischen dem Emitter und der Basis des Transistors mit der Temperatur und somit auch der
Stromfluß durch den Teilwiderstand (28) des
ersten Spannungsteilers und damit die Höhe der
vom Ausgangsanschluß des Temperaturfühlers
der Epitaxialschicht zugeführten Epitaxieschichtspannung ($V_{epi}$) ändert.

4. Temperaturkompensierter integrierter
Halbleiterwiderstand nach einem oder mehreren der Ansprüche 1 bis 3, dadurch gekennzeichnet, daß gleichzeitig mehrere nach Anspruch 1 gebildete integrierte Halbleiterwiderstände (11) von einem Temperaturfühler (24),
der in der nach Anspruch 2 angeführten Weise
angeschlossen ist, in ihrem jeweiligen Widerstandswert temperaturkompensierbar sind.

## Claims

1. A temperature compensated integrated
semiconductor resistor, comprising a resistance region of one conductivity type formed in
an epitaxial layer of the opposite conductivity
type, having electrical contacts spaced from
each other, characterised in that one of the electrical contacts (18; Fig. 1) is connected to a
reference potential, the resistor (8) has a positive voltage coefficient of resistance (VCR) and a
given temperature coefficient of resistance
(TCR), and a temperature sensor (24) is
provided which is thermally connected to the
integrated circuit in close proximity to the
resistor and which has its output voltage
terminal electrically connected to the epitaxial
layer (4) and its voltage reference terminal
connected to a reference potential, and that said
temperature sensor provides at its voltage
output terminal, a voltage output characteristic
with respect to temperature which varies
inversely with respect to the temperature coefficient of resistance of said resistor in such a
manner that variations in the resistance of the
resistor due to tmperature changes are
compensated by corresponding changes in the
voltage of the epitaxial layer induced by said
temperature sensor.

2. A temperature compensated integrated
semi-conductor resistor in accordance with
claim 1, characterised in that the temperature
sensor (24) has its output voltage terminal
connected to the epitaxial layer (4) via a first
contact (22, 12) and consists of two voltage
dividers (26, 28; 30, 32) connected in parallel,
the first voltage divider of which consists of a
component resistor (28) and a controllable
resistor (26) with a negative temperature
characteristic, the resistor (26) having a control
electrode which is connected to the tap of the
second voltage divider between its component resistors (30, 32); that the output voltage terminal is provided by the tap of the first voltage divider between the controllable resistor (26) and the component resistor (28); and that the supply voltage ($V_{cc}$) is applied to the connection between the two component resistors (28, 30) of the two voltage dividers.

3. A temperature compensated integrated semi-conductor resistor in accordance with claim 2, characterised in that the controllable resistor (26) is formed by an NPN transistor, the emitter-base voltage of which is maintained constant by the steady voltage drop between the supply voltage ($V_{cc}$) and the base of the transistor as a result of the constant supply voltage and the fixed ratio of the component resistors (30, 32) of the second voltage divider, so that the current flow through the PN depletion layer between the emitter and the base of the transistor changes as a function of the temperature and thus also the current flow through the component resistor (28) of the first voltage divider, and thus the magnitude of the epitaxial layer voltage ($V_{epi}$) applied from the output terminal of the temperature sensor of the epitaxial layer.

4. A temperature compensated integrated semiconductor resistor in accordance with any one or combination of claims 1 to 3, characterised in that several integrated semiconductor resistance regions (11) formed in an epitaxial layer as specified in claim 1, can be simultaneously temperature compensated with respect to their respective resistance value by a temperature sensor (24) connected in the manner specified in claim 2.

## Revendications

1. Résistance semi-conductrice intégrée à compensation de température comportant une région de résistance d'un type de conductivité dans une couche épitaxique du type de conductivité opposée, munie de contacts électriques espacés les uns des autres, caractérisée en ce que l'un des contacts électriques (18; Figure 1) est à un potentiel de référence, la résistance (8) a un coefficient positif de résistance par rapport à la tension (VCR) et un coefficient prédéterminé de résistance par rapport à la température (TCR), un détecteur de température (24) est connecté au circuit intégré très près, de la résistance, sa borne de tension de sortie étant connectée à la couche épitaxique (4) et sa borne d'alimentation de tension étant connectée à un potentiel de référence, et en ce que la caractéristique de tension de sortie du détecteur de température, par rapport à la température sur sa borne de sortie, varie inversement par rapport au coefficient de résistance par rapport à la tension de la résistance de telle sorte que les variations de résistance de ladite résistance en fonction de la température peuvent être compensées par les variations de tension provoquées par le détecteur de température sur la couche épitaxique.

2. Résistance semi-conductrice intégrée à température compensée selon la revendication 1, caractérisée en ce que le détecteur de température (24), connecté par sa borne de sortie à la couche épitaxique (4) à travers un premier contact (22, 12), est composé de deux diviseurs de tension (26, 28; 30, 32) montés en parallèle, le premier diviseur de tension étant composé d'une résistance partielle (28) et d'une résistance contrôlée (26) à caractéristique de température négative, dont l'électrode de commande est connectée à la prise du second diviseur de tension entre ses résistances partielles (30, 32), et en ce que la borne de tension de sortie est identique à la prise du premier diviseur de tension entre la résistance contrôlée (26) et la résistance partielle (28), et la tension d'alimentation ($V_{cc}$) est branchée sur la connexion entre les deux résistances partielles (28, 30) des deux diviseurs de tension.

3. Résistance semi-conductrice intégrée à température compensée selon la revendication 2, caractérisée en ce que la résistance contrôlée (26) est formée d'un transistor NPN dont la tension d'émetteur-base est maintenue constante par une chute de tension constante entre la tension d'alimentation ($V_{cc}$) et la base du transistor, résultant d'une tension d'alimentation constante et d'un rapport fixe des résistances partielles (30, 32) du second diviseur de tension, de sorte que le flux de courant à travers la couche d'appauvrissement PN entre l'émetteur et la base du transistor varie avec la température, entraînant ainsi la variation du flux de courant à travers la résistance partielle (28) du premier diviseur de tension et en conséquence de la valeur de la tension de couche épitaxique ($V_{epi}$) fournie à la couche épitaxique par la borne de sortie du détecteur de température.

4. Résistance semi-conductrice intégrée à température compensée selon l'une quelconque ou plusieurs des revendications 1 à 3, caractérisée en ce que plusieurs résistances semiconductrices (11) formées selon la revendication 1, peuvent être simultanément compensées en fonction de la température dans leur valeurs respectives de résistance par un détecteur de température (24) connecté comme spécifié dans la revendication 2.

TEMPERATURFÜHLER
(TSM)

+V_CC

30     28

26     N
       P
       N

32

24

+V_EPI        +V_R                                    SiO_2

22            20                              18

AL            AL                              AL

N+            P+            P            P+
12            10           8            6

P+                      N^- EPI                    P+
I_SO          4                                    I_SO

2        P SUBSTRAT

## FIG.  1

TCR
(25° 75°C)ppm/°C

4000

3000

2000

1000

0,1                    0,5        1,0                    5,0
SCHICHTWIDERSTAND    (KΩ/□)

## FIG.    2

1

0 000 863

FIG. 3